# EUROPEAN PATENT APPLICATION

(11) **EP 1 175 013 A1**
(43) Date of publication of application: **23.01.2002**
(21) Application number: 01116631.1
(22) Date of filing: 12.07.2001
(51) Int. Cl.: H03M 13/29

(54) **Method and apparatus for concatenated punctured encoding and decoding of a communications signal**

(30) Priority: 19.07.2000 US 619370
(71) Applicant: TRW Inc., Redondo Beach, California 90278 (US)
(72) Inventor: Berger, Harvey L., Redondo Beach, CA 90278 (US); Munoz, Michael S., Redondo Beach, CA 90278 (US)
(74) Representative: Schmidt, Steffen J., Dipl.-Ing.

(57) **Abstract**

A method and apparatus are provided for coding communications signals (16) carried between transmitting and receiving stations (12,14). A data stream from a communications signal is encoded with an outer code (22) to form an outer-coded data stream that is passed to an inner coder (26). The inner coder (26) applies an inner code and punctures the resulting coded data stream by deleting at least one bit from each symbol to achieve a desired data rate and coding level. The system (10) offers multiple levels of puncturing to vary the coding level between heavy and light. The inner code may be a Nordstrom-Robinson code and the outer code may be a Reed-Solomon code.

## Description

### BACKGROUND OF THE INVENTION

The preferred embodiments of the present invention generally relate to error detection and correction coding of a communications signal. In particular, the preferred embodiments of the present invention relate to concatenated punctured error correction encoding and decoding techniques used with a communications signal.

Communications systems have been proposed that relay communications signals between terminals, gateways, and/or ground stations through satellites and/or terrestrial towers. The communications signals are transmitted over return links and forward links to and from a satellite or terrestrial tower at predetermined power levels. Typically, it is desirable to minimize the power level at which signals are transmitted. However, as the transmission power is decreased, the number of errors in the received signal increases. Hence, a limit exists upon how low the power may be decreased for a given bit error rate.

In the past, satellite and terrestrial systems have been proposed that compensate, in part, for transmission and interference errors by encoding data carried in the communications signal before transmission with an error detection and correction coding scheme. Various encoding techniques have been proposed with such techniques offering different levels of complexity and error correctability. Generally, encoding schemes, having a high degree of error correctability, demand greater bandwidth than encoding schemes having a low degree of error correctability. For instance, a system using a (236, 212) Reed-Solomon (RS) encoder encodes 212 symbols or bytes of information data within a Reed-Solomon code of 236 bytes in length. Thus, the system transmits 236 encoded symbols or bytes to convey 212 data bytes, thereby increasing the data transmission bandwidth that must be supported by the system as compared to an uncoded data stream.

Data encoded solely with an RS code may be considered lightly coded. To increase the coding (heavy coding), the RS code may be combined, in a concatenated coding scheme, with another code which further increases the number of encoded bytes. Light coding may be preferable when the weather is clear, while heavy coding may be preferable in bad weather causing signal attenuation (e.g., rain).

Error detection and correction coding obtains more efficient satellite and/or terrestrial tower return link and forward link power usage at the expense of less efficient spectral (bandwidth) usage. In other words, additional error coding allows transmitters to send communications signals with less power at the expense of increased bandwidth. Applying error correcting codes to information in the return link signal at a terminal, gateway, ground station and the like helps reduce the effect of numerous sources of interference and noise that introduce errors into the signal. Error-correcting codes may lower the Bit Error Rate (BER) of the coded information, as received, to acceptable levels. The BER is generally defined as the ratio of incorrectly received information bits to the total number of received information bits for some measurement interval.

One example of a conventional error-correction code is concatenated coding. Generally, concatenated coding refers to a coding scheme in which two consecutive, separate codes are applied to information data. A concatenated coding scheme is divided into two levels of coding that are generally referred to as an inner code and an outer code. The outer code of the concatenated code is the first code applied to the data. The inner code is the second code and is applied to the outer coded data. The concatenated coded data is then transmitted. At the receiver, such as at a receiving tower, terminal, gateway, ground station or satellite, the inner code is decoded first, and then the outer code is decoded.

The first or outer code applied to the data may be a block code that forms codewords from blocks of information data. A codeword in a block code includes K information bits and R parity bits. The codeword is therefore N=K+R bits in length. Block codes are generally organized on the basis of bits or symbols.

A class of block codes known as Reed-Solomon codes may be used as the outer code to encode the return link signals. Reed-Solomon block codes are organized on the basis of groups of bits referred to as bytes, code letters or symbols (hereafter collectively referred to as symbols). To form symbols, an incoming serial data bit stream is reorganized as sequences of m individual bits, with each sequence representing a symbol. A Reed-Solomon code has K information symbols (rather than bits), R parity symbols and a total codeword length of N=K+R symbols. The number of bits in a symbol may vary. For 8-bit symbols, a Reed-Solomon codeword is typically 255 symbols in length. A multi-bit symbol may also be referred to as a symbol byte. Allowing the codeword to correct up to 16 symbols containing errors requires 32 parity symbols, thereby leaving 223 data symbols for an effective code rate of 223/255 [approximately 7/8].

An example of an inner code that has been applied in conventional systems is a convolutional code. A convolutional code is an error-correcting code that transforms an input sequence of bits into an output sequence of bits through a finite-state machine, where additional bits are added to the data stream to allow for error-correcting capability. Typically, the amount of error-correcting capability is proportional to the number of additional bits added and the memory present in the finite-state machine (encoder). The constraint length, L, of a convolutional code is proportional to the finite-state machine's memory. The rate of the convolution code (k/n, with k<n) describes how many additional bits or symbols are added for every k information bits or symbols (input) (i.e., n-k bits added for each k information bits or symbols). Convolutional codes are usually decoded using a Viterbi decoder. The complexity of the Viterbi decoder increases exponentially with the constraint length.

However, proposed systems have experienced certain problems. In particular, Viterbi decoders generate error bursts in the output signal when decoding received signals containing errors caused by noise. For instance, during transmission, a communications signal may encounter interference that manifests itself as noise in the received signal. The noise may only cause errors to be received in a limited number of received bits (e.g., 8 error bits) or symbols. However, the Viterbi decoder generates an error burst during the inner decoding operation that extends over a larger number of bits (e.g., 30 error bits) or symbols. The output of the Viterbi decoder is still encoded with an outer code, such as an RS code. Thus, the output of the Viterbi decoder is passed to the outer RS decoder. In the above example, a 30-bit error burst may extend over several RS symbols (e.g., four RS symbols). Hence, the RS decoder must then correct four consecutive erroneous symbols in one codeword. Burst errors may become long enough to render the RS codeword uncorrectable.

A processing technique that minimizes the adverse effects of burst errors is referred to as interleaving. The process of interleaving reorders symbols after encoding by the RS encoder, but before convolutional encoding and before transmission. The output of the Viterbi decoder is reordered or inverted, after reception and decoding of the inner code, but prior to decoding of the outer code. Once reordered, the Viterbi decoded data is decoded with the outer decoder. Interleaving is beneficial when the output of the inner decoder contains a burst error since interleaving spreads burst errors in the sequence deinterleaved after reception and thus increases the likelihood of accurate decoding. For instance, in the above example, interleaving spreads burst errors among several RS codewords. Therefore, four erroneous symbols produced consecutively by the Viterbi decoder are separated during interleaving over four separate RS codewords. Unfortunately, interleaving code sequences takes time, power and computational resources, and adds to the overall complexity of the communications system.

Commonly used coding methods experience two difficulties when processing information received on a return link. First, an interleaver is impractical in most forms of return link access because of the significant latency (i.e., additional delay) arising when interleaving is applied to a low-speed application. Second, the process of Viterbi decoding consumes a significant amount of satellite power which is a scarce resource. The second problem is due primarily to the fact that, for convolutional inner codes, decoding complexity increases exponentially with the constraint length.

Also, conventional decoding techniques, whether concatenated or not, offer very few options as to the amount of error correction capability offered by a particular system. For instance, a system relying entirely on RS coding is lightly encoded, and thus may require excess power. Adding an inner convolutional code results in a heavily encoded data stream, and thus may require excess bandwidth. Some outer codes may double the data content and bandwidth. Heretofore, proposed systems were capable only of offering limited coding options that greatly differed in the amount of coding, namely light coding and heavy coding. The systems switched between light and heavy coding by turning the outer convolution coder on and off. Systems offering two levels of coding were not adaptable to intermediate demands.

Further, heavy coded systems typically used Viterbi decoders, thereby requiring interleaving. As noted above, interleaving increases processing complexity, power demand, and time. In addition, interleaving is only useful with systems that transmit long or continuous data streams. The receiver interleaves symbols between different data packets encoded with different codewords (e.g., 256 symbols). If the interleaving technique interleaves symbols between four codewords, then at least four data packets must be transmitted. Short data bursts, such as a request for a web page and the like, may be limited to a single data packet and single codeword, and thus cannot be interleaved. Return link signals commonly comprise short data bursts, while forward link signals commonly include continuous data streams. Hence, interleaving is more useful with forward links. Return links still experience the problems associated with bust errors.

A need has long existed for a simple, flexible and effective error control method and apparatus that may be used in the return link and forward link of a communications system.

### BRIEF SUMMARY OF THE INVENTION

A method is provided according to a preferred embodiment of the present invention for coding communication signals carried over one of a return link and forward link. The method comprises encoding a data stream of a communications signal with an outer code to form an outer-coded data stream. The outer-coded data stream is further encoded with a punctured inner code to form a punctured inner-coded data stream that is then transmitted over the return link or forward link. The outer code may represent a Reed-Solomon code, and the inner code may represent a Nordstrom-Robinson code.

According to an embodiment of the present invention, the method applies an inner codeword to the outer-coded data stream to form an inner-coded data stream and deletes at least a portion of the inner-coded data stream to form the punctured inner-coded data stream. Predetermined bits may be deleted during the second encoding step to achieve a desired maximum bandwidth while maintaining a minimum distance between symbols in the punctured inner-coded data stream that equals a minimum distance between codewords in an associated unpunctured codeword.

According to yet a further alternative embodiment of the present invention, a method is provided that defines multiple levels to which the inner code may be punctured. Different puncturing levels are selected based upon system conditions, including an amount of attenuation experienced by the communications link between transmitting and receiving stations.

According to a further alternative embodiment of the present invention, a communications satellite system is provided comprising a satellite for relaying encoded communications data to and from return links and forward links. The system includes at least one station for transmitting communications data to the satellite. At least one of the satellite and the station comprise an outer coder encoding a data block with an outer codeword to form an encoded data block and a punctured inner coder. The punctured inner coder encodes the encoded data block with an inner codeword and forms punctured data blocks for transmission.

The station may further comprise a puncture control module controlling the amount of puncturing applied to the punctured data block. The inner and outer coders may represent Reed-Solomon and Nordstrom-Robinson coders, respectively. The inner coder may delete a portion of a data block formed by the outer coder. The inner coder may delete predetermined bits from each symbol in a data block, the positions of which are selected to maintain a minimum distance between symbols in the punctured data blocks that equals a minimum distance between codewords in an associated unpunctured inner code. The inner coder selects one of at least two levels of puncturing to perform upon the data blocks.

According to a further alternative embodiment of the present invention, at least one of the satellite and station include a receiver receiving punctured data blocks and inner and outer decoders. The inner coder decodes the received data blocks, and the outer coder decodes the output of the inner decoder.

According to a further alternative embodiment of the present invention, a method is provided for decoding communications signals carried over one of a return link and forward link. The method comprises the steps of receiving a data stream encoded with a punctured inner code and outer code. The outer code may be a block code, such as a Reed-Solomon code. The inner code may be a Nordstrom-Robinson code. The method further includes decoding the punctured inner code from the received data stream to form an outer-coded data stream. The outer-coded data stream is then decoded to form a decoded data stream.

### BRIEF DESCRIPTION OF THE DRAWINGS

Figure 1 illustrates a block diagram of a communications system according to a preferred embodiment of the present invention.
Figure 2 illustrates data structures used in accordance with a preferred embodiment of the present invention.
Figure 3 illustrates a performance for various punctured NR codes comparing decoding failure rate and E_{c}/Nₒ.

### DETAILED DESCRIPTION OF THE INVENTION

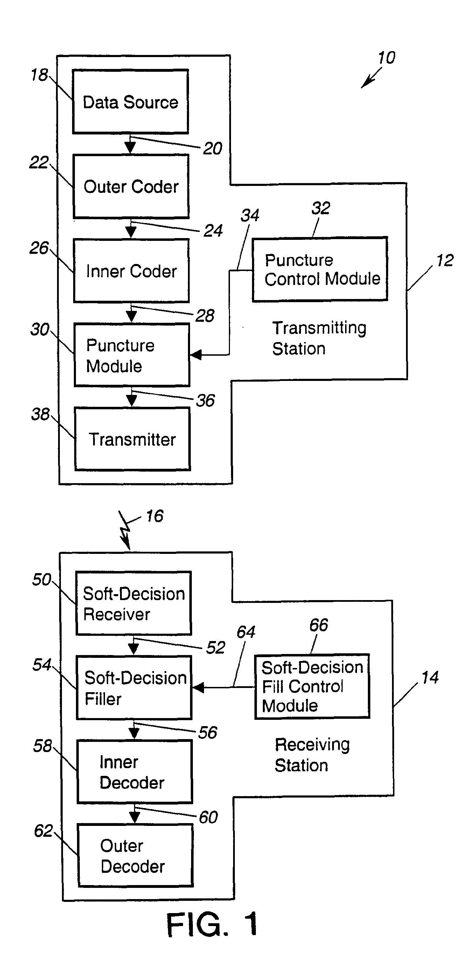

Figure 1 generally illustrates a preferred embodiment of the present invention. Figure 1 illustrates a communications system 10 that may embody a satellite-based system or a terrestrial-based system. The communications system includes at least two stations generally referred to as a transmitting station 12 and a receiving station 14 that operate at dynamically variable power and bandwidth levels. The power and bandwidth levels, at which stations 12 and 14 operate, are selectable from multiple predetermined levels and may be adjusted during operation. The transmitting station 12 passes communications signals via a communications link 16 to the receiving station 14. The communications link 16 may represent a radio frequency signal, an infrared signal and the like. The communications link 16 may constitute a return link from a ground-based station, gateway, user terminal and the like to a satellite/radio tower, or alternatively a forward link from a satellite/radio tower to a ground-based station, gateway, user terminal and the like.

The transmitting station 12 encodes and transmits. communications data to the receiving station 14 which in turn decodes the received signal. The transmitting and receiving stations 12 and 14 implement predetermined encoding/decoding algorithms with selectable levels of encoding/decoding. The communications system 10 may dynamically change the amount of encoding/decoding by instructing the transmitting and receiving stations 12 and 14 to adjust the level of coding to one of a predetermined number of coding options.

The transmitting station 12 includes a data source 18 that produces a stream of communications data in an uncoded binary format. The communications data stream 20 is provided to an outer coder 22 that implements a predetermined coding technique to form outer coded data blocks 24 that are passed to an inner coder 26. By way of example only, the outer coder 22 may represent a block coder, whereby the communications data stream 20 is divided into blocks of data, each of which includes a predetermined number of symbols.

For instance, a symbol may constitute 1, 3, 8, 16 bits and the like. Optionally, the outer coder 22 may divide the communications data stream 20 into data blocks, for example 212 symbols. The number of data symbols forming each data block may be varied depending upon the type of outer coder. Alternatively, the outer coder 22 may be adjusted dynamically and during operation to vary the size of the data block, such as by changing from a 212-symbol block to a 236-symbol block. The outer coded data block typically has a length, including the symbols in the unencoded data block, plus an additional number of symbols to support error correction and detection. For instance, the additional symbols may include parity symbols and the like. By way of example only, the outer coder 22 may construct Reed-Solomon encoded data blocks of 236 symbols in length based upon information data blocks of 212 symbols in length.

The inner coder 26 applies a second coding technique to the outer coded data block 24. By way of example, the inner coder 26 may represent a (16, 8) Nordstrom Robinson encoder. The nomenclature (16, 8) indicates that the exemplary Nordstrom Robinson (NR) encoder produces a 16-bit output codeword for each incoming 8-bit input symbol. Optionally, the symbol size may differ for symbols within the outer coded data block 24 and for codewords formed by the inner coder 26. The inner coder 26 produces an inner-coded data block 28 that is passed to a puncture module 30. The puncture module 30 deletes one or more bits from each codeword in the inner-coded data block 28. The number of bits deleted from each codeword in the inner-coded data block 28 by the puncture module 30 is controlled by a puncture-control module 32. The puncture control module 32 outputs a symbol puncture level signal 34 identifying the number of bits to be deleted (and their locations) from the codewords in inner-coded data block 28. The puncture module 30 produces a puncture-coded data block 36 that is passed to the transmitter 38 and transmitted over the communications link 16.

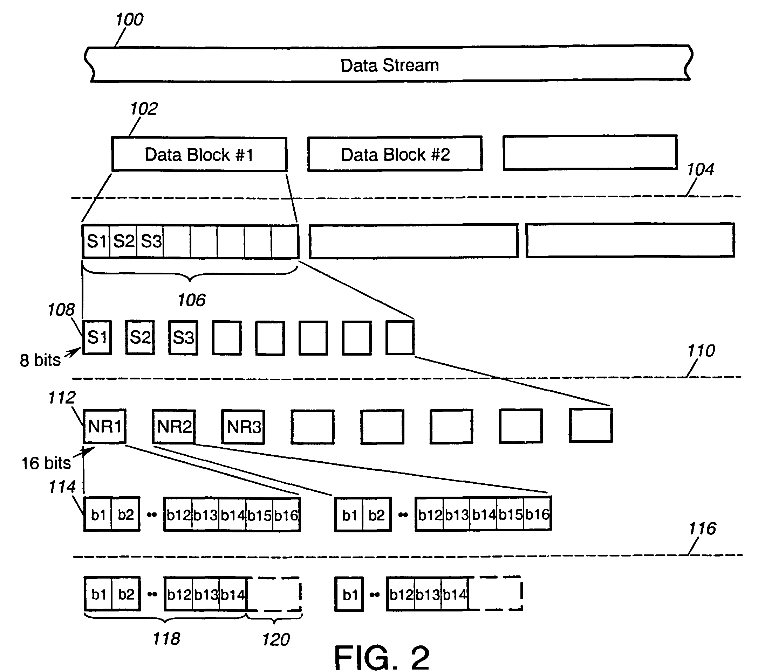

Figure 2 illustrates exemplary data structures utilized in connection with a preferred embodiment of the present invention during an encoding operation. A portion of a data stream 100 is illustrated that may represent continuous or intermittent information in an uncoded format. The data stream 100 is divided, during the outer encoding operation, into data blocks 102. Each data block 102 includes a predetermined number of symbols, such as 212, 236 and the like. Each data block 102 is passed to the outer encoder (conceptually designated by the dashed line 104). Each data block 102, after being encoded with an outer code, is transformed into an outer-encoded data block 106. Each outer-encoded data block 106 comprises a series of symbols (designated as S1, S2, etc.). Each symbol comprises a predetermined number of bits, based upon the particular outer-encoding algorithm. By way of example, the outer-encoded data block 106 may include 236 symbols, each of which comprises eight bits.

The symbols 108 in the outer-encoded data block 106 are then passed through the inner coder (conceptually designated by dashed line 110) to form concatenated codewords 112. By way of example, the concatenated codewords 112 may represent Nordstrom-Robinson codewords. The concatenated codewords 112 each comprise a predetermined number of bits 114. For instance, each eight-bit symbol 108 may be encoded to form a 16-bit Nordstrom-Robinson codeword. The concatenated codewords 112 are punctured (conceptually designated by dashed line 116), whereby one or more bits is deleted from each codeword 112. The puncturing operation 116 forms, from each concatenated codeword 112, a punctured or shortened codeword 118. In the example of Figure 2, the shortened codewords 118 include 14 bits. The last two bits of each codeword 112, B15 and B16, are deleted (as designated by the hyphenated portion identifying the deleted bits 120). By deleting bits 120 from each concatenated codeword 112, the system 10 reduces the total data that must be transmitted over the communications link 16.

The inner coder 26 may perform Nordstrom-Robinson coding according to any of several known algorithms. Various constructions have been proposed for the (16, 8, 6) extended Nordstrom Robinson code that are equivalent by permuting the 16 components or bits within each symbol, as described more fully in an article entitled "An Optimum Nonlinear Code," by Allen W. Nordstrom and John P. Robinson, Information and Control, November-December 1967, pages 613-616, the subject matter of which is incorporated herein in its entirety by reference. The nomenclature (16, 8, 6) indicates that for every 8-bit symbol received by the extended NR code, an encoded symbol of 16 bits is produced, such that the minimum distance between two codewords is at least 6 bits. An alternative procedure for constructing an NR code has been proposed by F.J. Williams and N.J.A. Sloane in a book entitled "The Theory of Error-correcting Codes," North Holland, 1977, the subject matter of which is incorporated herein by reference in its entirety. According to Williams and Sloane, the NR code may be constructed from an extended Golay code. An article Adoul, Jean-Pierre, titled "Fast ML Decoding Algorithm for the Nordstrom-Robinson code," IEEE Transactions on Information Theory, Vol. IT-33, No. 6, November 1987, pages 931-933, describes a construction for the (16, 5, 8) Reed-Muller code where the extended Nordstrom-Robinson code is the union of the (16, 5, 8) Reed-Muller code and 7 "translations." The Adoul article is incorporated herein in its entirety by reference. An article by Vardy has proposed constructing the Nordstrom-Robinson code as the union of two isomorphic quadracodes over the Galois field of four elements, GF (4), Alexander Vardy, "The Nordstrom-Robinson Code: Representation over GF (4) and Efficient Decoding," IEEE Transactions on Information Theory, Vol. 40, No. 5, September 1994, pages 1686-1693, the subject matter of which is incorporated by reference in its entirety.

The inner decoder 58 performs decoding according to any one of several known algorithms, such as proposed by Vardy in the above referenced article. A reduced complexity soft decision decoding algorithm has been proposed by the assignee of the present application based upon the construction of the NR code as the union of two isomorphic quadracodes over GF (4). The reduced complexity soft decision decoding algorithm is described in detail in a copending application entitled "Apparatus for Error Correction Decoding a Nordstrom-Robinson Encoded Data Stream," TRW Docket No. 22-0088, filed on even date herewith, the subject matter of which is incorporated by reference herein in its entirety, including the specification, claims, abstract, drawings and the like.

By way of example, the inner coder 26 and outer coder 22 may cooperate such that an extended NR code may be concatenated with an 8-bit Reed-Solomon outer code in order that each NR codeword corresponds to a Reed-Solomon symbol. The puncture module 30 may puncture each (16, 8) extended Nordstrom-Robinson code based on one of several predefined puncturing routines, such as (15, 8), (14, 8), (13, 8), (12, 8), (11, 8), (10, 8), (9, 8) codes and the like by deleting 1, 2, 3, 4, 5, 6, 7 bits and the like from each symbol. The following table illustrates exemplary puncture levels, defining a number of bits that may be deleted from each symbol in the inner-coded data blocks 28 generated by the inner coder 26.

**Table 1**

| **Number of Bits** | **Code** | **Code Rate** | **Puncture Bits** |
|---|---|---|---|
| 0 | (16,8) | 1/2 | None |
| 1 | (15, 8) | 8/15 | 16 |
| 2 | (14, 8) | 4/7 | 15, 16 |
| 3 | (13, 8) | 8/13 | 14, 15, 16 |
| 4 | (12, 8) | 2/3 | 13, 14, 15, 16 |
| 5 | (11, 8) | 8/11 | 12, 13, 14, 15, 16 |
| 6 | (10, 8) | 4/5 | 11, 12, 13, 14, 15, 16 |
| 7 | (9, 8) | 8/9 | 12, 11, 12, 13, 14, 15, 16 |

Table 1 illustrates, in the left-hand column, the number of bits that may be deleted from each symbol to achieve various levels of puncturing and associated data rates. The second column indicates the type of resulting punctured code based upon the number of bits to be deleted from each symbol. The third column indicates a coding rate that is achieved by the combination of the inner coder 26 and puncture module 30, while the fourth column indicates the position(s) of exemplary bits within each symbol that may be deleted.

For instance, the example of first row indicates that no bits are deleted from incoming symbols, thereby achieving a (16, 8) NR code having a coding rate of one-half, and in which no bits are deleted. The fourth row of Table 1 indicates an example whereby three bits are deleted from each symbol to achieve a (13, 8) NR code having an 8/13 coding rate. The 14^{th}, 15^{th}, and 16^{th} bits may be deleted from each symbol to achieve the (13, 8) NR code. The last column of Table 1 illustrates an example whereby 7 bits are deleted from each symbol to attain a (9, 8) NR code having an 8/9 code rate. By way of example only, the last seven bits (10^{th}-16^{th} bits) may be deleted from each symbol. Alternatively, other bits within each symbol may be deleted. For example, the (15, 8) NR code may be attained by deleting the first bit in each symbol. Alternatively, any other bit may be deleted. Similarly, for each of the codes indicated in Table 1, any combination and/or sequence of bits may be deleted from each symbol to attain the desired coding rate and code.

The examples of Table 1 illustrate a range for coding levels, within which the (16, 8) NR code represents a heavily encoded data stream, while the (9, 8) NR code affords an intermediate level of coding. Lighter coding may be achieved by deleting more bits from each symbol. In the example of Table 1, the communications system 10 is afforded eight coding levels for use during operation.

The level of puncturing may be adjusted during operation by directing the transmitting station 12 and receiving station 14 to reconfigure for a new desired amount or level of puncturing. For example, on a clear day, the communications link 16 may experience little attenuation, and, thus the puncture control module 32 may direct the transmitting station 12 to implement a light coding technique, such as the (9, 8) code noted in the eighth column of Table 1. By selecting the (9, 8) code, the system 10 achieves a 8/9 code rate. However, during bad weather, the communications link 16 may experience excess attenuation and thus require additional coding to maintain signal integrity. Thus, the puncture control module 32 may select an NR code having heavy coding, such as the (14, 8), (15, 8), or (16, 8) codes. The heavier encoding techniques reduce the data rate but maintain signal integrity.

The puncture module 30 may select any of the bits within each symbol to be deleted, provided that the selected bit/bits does not unduly affect the minimum distance of the code. As noted above, an NR code offers a minimum distance of six when unpunctured. In general, it may be desirable to maintain the minimum distance of six. However, in certain instances, the minimum distance may be reduced to five, four or less, depending upon the system's needs. The effect upon the minimum distance of the bits selected for deletion is dependent upon the decoding algorithm to be used. For instance, a maximum likelihood decoding algorithm, when used with an NR code, renders puncturing distance invariant, since the minimum distance of six is maintained regardless of which of the 16 bits is deleted. However, other decoding algorithms may be sensitive to the selection of which bits are deleted. For example, the soft-decision decoding algorithm noted above and proposed by the assignee of the present application is sensitive to the location of the punctured bits. Preferably, the soft-decision decoding algorithm proposed by the assignee of the present invention affords its best performance when the locations of the punctured bits follow the designation note above in the fourth column of Table 1.

The communications link 16 carries punctured coded data blocks to the receiving station 14, including a receiver 50. The receiver 50 passes punctured coded soft decisions 52 to a symbol filler module 54 that inserts "zero" soft decisions into each punctured position in the punctured coded data blocks 52. The soft-decision filler module 54 outputs symbols 56 to the inner decoder 58 which decodes each symbol. The inner decoder 58 outputs an outer-coded data block 60 that is passed to an outer coder 62 for further decoding.

The soft-decision filler module 54 inserts a number of "zero" soft-decisions 64 designated by the filler control module 66. The fill control module 66 receives information from the receiving station 14 related to the puncture rate used by the puncture control module 32.

The codes proposed in Table 1 may be useful with systems proposed by the assignee of the present invention. The return link may use a Reed-Solomon (236, 212) outer code to construct data blocks, including 236 encoded symbols based upon 212 incoming information symbols. The cell loss rate preferably does not exceed 3 x 10⁻⁸. The cell loss rate corresponds to the decoder failure rate for a Reed-Solomon outer code. Thus, in the foregoing example, the cell loss rate corresponds to a Reed-Solomon input symbol error rate of 7.30 x 10⁻³. In the present example, each Nordstrom-Robinson codeword represents an eight-bit Reed-Solomon symbol. Thus, the Nordstrom-Robinson decoding failure rate should not exceed 7.30 x 10⁻³.

The inner decoder 58 may include any of several well-known algorithms. Alternatively, the inner decoder 58 may implement the soft-decision decoder described in the above-identified application assigned to the assignee of the present application. The inner decoder 58 operates as an unpunctured decoder since the soft decision fill module 54 inserts any necessary soft-decisions required. Thus, a single decoding algorithm may be used with any desired level of puncturing.

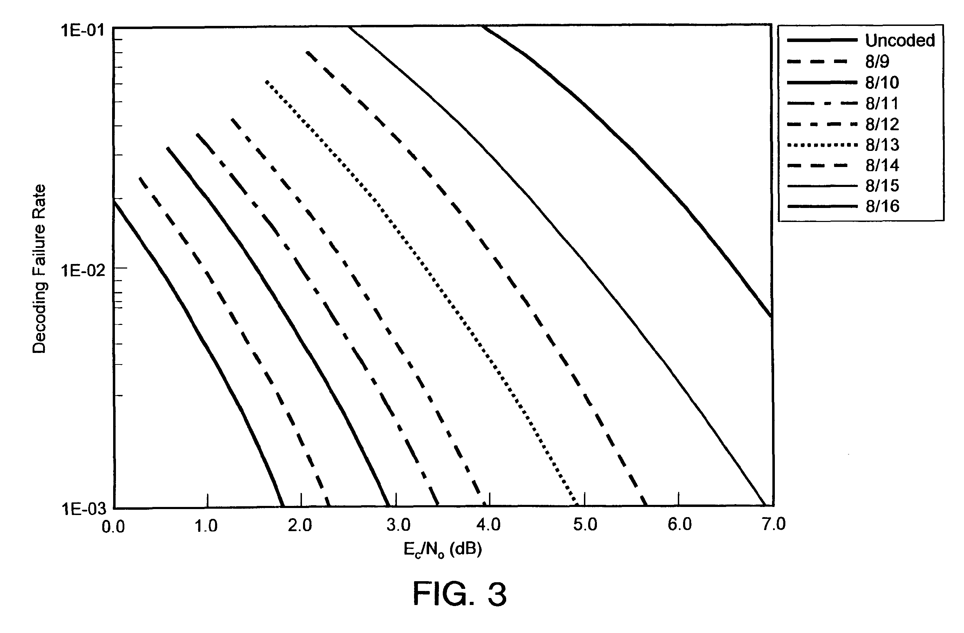

Performance of a system incorporating the above-discussed exemplary punctured codes has been simulated, and its performance verified through modeling for each of 256 codewords used in an NR code. During the modeling, when puncturing by four and six bits, half of the codewords exhibited one decoding failure rate, while the other half of the codewords exhibited a different decoding failure rate when implementing the soft-decision decoding algorithm set forth in the patent application noted above assigned to the assignee of the present application. The bi-level performance with different failure rates occurred with the above-discussed reduced complexity bounded distance decoding algorithm and did not occur with a conventional maximum likelihood decoding algorithm. While bi-level failure rates may be eliminated from the reduced complexity algorithm, the difference in performance represents a small amount (e.g., a few tenths of a dB in benefit) and may not warrant the additional complexity. The NR decoding failure rate is tabulated below in Table 2 and illustrated graphically in Figure 3. The decoding failure rates in Table 1 and Figure 3 have been averaged over 256 codewords.

**Table 2**

| **Number of Puncture Bits** | **Code** | **Code Rate** | **Required E**_{**c**}**/N**_{**o**} **(dB)** |
|---|---|---|---|
| 0 | (16, 8) | 1/2 | 0.8 |
| 1 | (15, 8) | 8/15 | 1.2 |
| 2 | (14, 8) | 4/7 | 1.8 |
| 3 | (13, 8) | 8/13 | 2.3 |
| 4 | (12, 8) | 2/3 | 2.8 |
| 5 | (11, 8) | 8/11 | 3.7 |
| 6 | (10, 8) | 4/5 | 4.4 |
| 7 | (9, 8) | 8/9 | 5.3 |
| Uncoded | Uncoded | 1 | 6.9 |

Table 2 represents a required E_{c}/Nₒ vs. puncture bits for a decoding failure rate of 7.3 x 10⁻³. The E_{c}/Nₒ may be 6.9 dB, by way of example, for a data transmission only encoded with a Reed-Solomon code (light coding) . The E_{c}/Nₒ may be 0.8 dB, by way of example, for a concatenated coded transmission, including Reed-Solomon coding and full NR coding (heavy coding). Between these two extremes, the above examples provide seven intermediate coding options or candidates. One option is the 2/3 code rate afforded by a (12, 8) code that offers 4.1 dB of coding gain relative to light coding with only a 33% reduction in data throughput.

The (12, 8) punctured NR code, as an intermediate code, was also compared with a (12, 8) shortened Hamming code. The weight distribution of the (16, 8) unpunctured NR code is illustrated below in Table 3.

**Table 3**

| i | 0 | 6 | 8 | 10 | 16 |
|---|---|---|---|---|---|
| A_{*i*} | 1 | 112 | 30 | 112 | 1 |

The first row of Table 3 identifies the number of "1s" contained within each codeword, while the second row identifies the number of codewords containing the number of "Is" designated in the first column. For instance, the second row indicates that one codeword in the unpunctured NR code includes 0 "1s," while the third column indicates that 112 codewords include six "1s."

Table 4 below illustrates the weight distribution of the (12, 8) punctured Nordstrom-Robinson code.

**Table 4**

| i | 0 | 3 | 4 | 5 | 6 | 7 | 8 | 9 | 12 |
|---|---|---|---|---|---|---|---|---|---|
| A_{*i*} | 1 | 16 | 39 | 48 | 48 | 48 | 39 | 16 | 1 |

In comparison, the weight distribution of the (12, 8) shortened Hamming code is as illustrated below in Table 5.

**Table 5**

| i | 0 | 3 | 4 | 5 | 6 7 | | 8 | 9 | 10 | 11 | 12 |
|---|---|---|---|---|---|---|---|---|---|---|---|
| A_{*i*} | 1 | *17* | 38 | 44 | 52 | 54 | 33 | 12 | 4 | 1 | 0 |

As shown above, the first row of Table 5 indicates the number of "1s" within a codeword, while the second row indicates the number of codewords containing the number of "1s" indicated in the first row. For example, in a (12, 8) shortened Hamming code, 52 codewords include 6 "1s." As evidenced by Tables 3-5, the punctured Nordstrom-Robinson code exhibits better weight distribution than the (12, 8) shortened Hamming code, and thus performs slightly better. In addition, a further advantage of the punctured NR code is that the punctured NR code is able to use a common decoding algorithm as the unpunctured NR code and for all levels of puncturing, thereby providing intermediate codes without adding decoding complexity.

While particular elements, embodiments and applications of the present invention have been shown and described, it will be understood, that the invention is not limited thereto since modifications may be made by those skilled in the art, particularly in light of the foregoing teachings. It is, therefore, contemplated by the appended claims to cover such modifications as incorporate those features which come within the spirit and scope of the invention.

## Claims

1. A method for concatenated coding of communications signals carried over one of a return link and forward link, the method comprising the steps of:
encoding a data stream of a communications signal with an outer code to form an outer-coded data stream;
encoding the outer-coded data stream with a punctured inner code to form a punctured inner coded data stream; and
transmitting the punctured inner coded data stream.

2. The method of claim 1, further comprising the steps of:
applying a Reed-Solomon code as the outer code, and/or
applying a Nordstrom-Robinson code as the inner code.

3. The method of claim 1, further comprising the step of:
applying an inner codeword to the outer coded data stream to form an inner coded data stream; and
deleting at least a portion of the inner-coded data stream to form the punctured inner-coded data stream.

4. The method of claim 1, further comprising the step of:
defining multiple levels to which the inner code may be punctured;
selecting one puncturing level.

5. A communications satellite system, comprising:
a satellite for relaying encoded communications data to and from return links an forward links; and
a station for at least one of transmitting and receiving communications data to and from the satellite, at least one of the satellite and the station comprising:
an outer coder encoding a data block with an outer codeword to form an encoded data block; and
a punctured inner coder encoding the encoded data block with an inner codeword and forming punctured data blocks for transmission.

6. The communications satellite system of claim 5, wherein the station further comprises:
a puncture control module controlling a number of bits to be deleted from the punctured data block.

7. The communications satellite system of claim 5, wherein said outer coder is a Reed-Solomon coder, and/or wherein said inner coder is a punctured Nordstrom-Robinson coder.

8. The communications satellite system of claim 5, wherein at least one of the satellite and stations comprise;
a receiver receiving punctured data blocks;
an inner decoder decoding the punctured inner code from the received punctured data block; and
an outer decoder decoding an output of the inner decoder to form a decoded data stream.

9. A method for decoding communications signals carried over one of a return link and forward link, the method comprising the steps of:
receiving a data stream encoded with a punctured inner code and an outer code;
decoding the punctured inner code from the received data stream to form an outer coded data stream; and
decoding the outer code from the outer coded data stream to form a decoded data stream.

10. The method of claim 9, further comprising the step of:
adding neutral soft decisions in the received data stream to form a set of soft decisions having a length associated with an unpunctured inner code.

11. The method of claim 9, further comprising the steps of:
applying a Reed-Solomon code as the outer code, and/or
applying a Nordstrom-Robinson code as the inner code.

12. The method of claim 9, further comprising the step of:
applying an (k-p, h) Nordstrom-Robinson (NR) punctured code as the inner code, where h represents the number of information symbols, k represents the number of NR codewords per NR encoded data block, and p represents the number of symbols deleted from the NR encoded data block.
